# EUROPÄISCHE PATENTSCHRIFT

(11) **EP 3 149 817 B1**
(45) Veröffentlichungstag und Bekanntmachung des Hinweises auf die Patenterteilung: **26.02.2020**
(21) Anmeldenummer: 15725999.5
(22) Anmeldetag: 27.05.2015
(51) Int. Cl.: H02B 1/56

(54) **KLIMATISIERUNGSANORDNUNG**
AIR CONDITIONING ASSEMBLY
INSTALLATION DE CLIMATISATION

(30) Priorität: 27.05.2014 DE 102014007901
(43) Veröffentlichungstag der Anmeldung: 05.04.2017
(73) Patentinhaber: Friedrich Lütze GmbH, 71366 Weinstadt-Grossheppach (DE)
(72) Erfinder: ROTHE, Elmar, 99098 Erfurt (DE)
(74) Vertreter: Bartels und Partner, Patentanwälte
(86) Internationale Anmeldenummer: PCT/EP2015/001090
(87) Internationale Veröffentlichungsnummer: WO 2015/180843

(56) Entgegenhaltungen:
- EP-A2- 2 224 561
- WO-A1-2013/083421
- DE-A1-102006 055 755
- DE-A1-102012 007 089

## Beschreibung

Die Erfindung betrifft eine Klimatisierungsanordnung, insbesondere Kühlanordnung, zumindest aufweisend einen Schaltschrank mit einer Trageinrichtung, an deren den Schaltschranktüren zugewandten Vorderseite zu klimatisierende elektrische und/oder elektronische Geräte in Etagen überund nebeneinander angeordnet sind gemäß der Merkmalsausgestaltung des Oberbegriffes des Patentanspruches 1.

Durch die DE 10 2009 054 011 B4 ist eine gattungsgemäße Kühlanordnung für in einem Schaltschrank angeordnete elektrische Geräte bekannt, aufweisend einen Schaltschrank mit einer Trageinrichtung, an deren Vorderseite die elektrischen Geräte in Etagen über- und nebeneinander angeordnet sind, und eine Luftfördereinrichtung, mit der auf der Rückseite der Trageinrichtung eine Luftströmung von oben nach unten erzwingbar ist, bei der durch mehrere in Vertikalrichtung und/oder Horizontalrichtung voneinander beabstandete Durchtrittsöffnungen ein von der Luftströmung an der Rückseite der Trageinrichtung abgezweigter Teilluftstrom den an der Vorderseite der Trageinrichtung angeordneten zu kühlenden elektrischen Geräten gezielt zuführbar ist.

Bei dieser bekannten Lösung ist vorgesehen, dass bei aufgestelltem Schaltschrank die Trageinrichtung horizontal verlaufende Montagestege aufweist, an denen zumindest ein Teil der Geräte befestigt ist, wobei zwischen zwei in Vertikalrichtung benachbarten Montagestegen ein Stegzwischenraum vorhanden ist, in dessen Bereich die Durchtrittsöffnungen angeordnet sind, und wobei der dahingehende Stegzwischenraum zum Hindurchführen der elektrischen Anschlussleitungen der Geräte dient.

Insbesondere in der industriellen Steuerungstechnik werden elektrische und/oder elektronische Geräte häufig in Schaltschränken oder Schaltkästen angeordnet. Die einzelnen Geräte entwickeln während des Betriebes eine zum Teil erhebliche Verlustwärme, was zu einer Temperaturerhöhung innerhalb des Schaltschranks führt. Damit die Funktionsfähigkeit der Geräte gewährleistet ist, darf die Temperatur einen Maximalwert nicht überschreiten. So können in den Geräten eingebaute Halbleiterbauelemente nur bis zu einer Bauelementetemperatur von beispielsweise 85°C oder 125°C funktionssicher betrieben werden.

Bei der Entwicklung der bekannten Lösung nach der DE 10 2009 054 011 B4 ist erkannt worden, dass auf der Rückseite des Schaltschrankes und auf dessen Innenseite strömende Luft vergleichsweise kühl ist, beispielsweise weil über die rückseitige Wand des Schaltschrankes eine Kühlung des Schaltschrankinneren erfolgt oder weil in diesem Bereich kühle Luft zugeführt wird, beispielsweise durch die Zufuhr von kühler Außenluft oder durch die Zufuhr von über einen Wärmetauscher gekühlter Luft. Eine passive Kühlung kann darüber hinaus durch Wärmeabstrahlung des Schaltschrankes erfolgen oder durch Kühlung der Außenseite des Schaltschrankes durch die Umgebungsluft.

Durch die gezielte Durchführung der Kühlluft durch die Durchtrittsöffnungen der Trageinrichtung können auf deren Vorderseite gebildete Wärmenester aufgelöst werden, was insbesondere für den Fall gilt, dass die Durchtrittsöffnungen im Bereich sich etwaig bildender Wärmenester angeordnet sind, die regelmäßig zwischen in Vertikalrichtung gesehen benachbarten Geräten entstehen können. Derartige Wärmenester können sich des Weiteren auch auf der Lee-Seite der auf der Vorderseite des Tragrahmens angeordneten Geräte bilden, d.h. auf der von der auf der Vorderseite des Tragrahmens strömenden Luft abgekehrten Seite eines elektrischen Geräts, was insbesondere dann der Fall ist, wenn das Gerät großvolumig oder großflächig konzipiert ist. Die Durchtrittsöffnungen können daher bei der bekannten Lösung bevorzugt auf der Lee-Seite der Geräte angeordnet sein, so dass die hindurchströmende Kühlluft unmittelbar in das jeweilige Wärmenest hineinbläst und dieses dadurch aufgelöst wird. Dennoch lässt die bekannte Lösung, was die Klimatisierungs-, insbesondere Kühlleistung anbelangt, noch Wünsche offen.

Durch WO 2013/083421 A1 ist ein gattungsgemäßer Schaltschrank bekannt, der einen vorderen Teil und einen hinteren Teil aufweist und dazu bestimmt ist, funktionale elektrische Einheiten aufzunehmen, die jeweils einen Träger und mehrere elektrische Geräte, die auf einer vorderen Fläche des Trägers oder einer hinteren Fläche des Trägers angeordnet sind oder durch den Träger verlaufen, umfassen, wobei der Schaltschrank außerdem Folgendes umfasst:
- Mittel zum Befestigen der funktionalen elektrischen Einheiten, wobei die Befestigungsmittel dafür ausgelegt sind, die Träger der funktionalen elektrischen Einheiten längs einer Trennebene, die einen ersten Raum, der sich auf Seiten des vorderen Teils des Schaltschranks befindet, und einen zweiten Raum, der sich auf Seiten des hinteren Teils des Schaltschranks befindet, begrenzt, aufzunehmen,
- wobei in dem zweiten Raum ein Luftstrom zirkuliert,
- eine Kühlungsquelle, die dazu bestimmt ist, in Kontakt mit dem Luftstrom angeordnet zu sein,
- eine Trennwand, die sich längs einer vertikalen Ebene parallel zu der Trennebene erstreckt und den zweiten Raum in einen ersten Unterraum, der sich auf Seiten des vorderen Teils des Schaltschranks befindet, und einen zweiten Unterraum, der sich auf Seiten des hinteren Teils des Schaltschranks befindet, unterteilt, wobei die Trennwand in dem Schaltschrank angeordnet ist, um wenigstens zwei Durchlässe zu bilden, die dem Luftstrom ermöglichen, zwischen dem ersten Unterraum und dem zweiten Unterraum zu zirkulieren,
- eine kalte thermische Zone, die durch den ersten Raum gebildet ist und dazu vorgesehen ist, die elektrischen Geräte oder Teile elektrischer Geräte, die sich nicht oder nur sehr wenig erhitzen, aufzunehmen,
- eine zur wärmende thermische Zone, die durch den ersten Unterraum des zweiten Raums gebildet ist und dazu bestimmt ist, Geräte oder Teile von Geräten, die sich erwärmen, aufzunehmen,
- eine kühlende thermische Zone, die durch den zweiten Unterraum des zweiten Raums gebildet ist und mit der Kühlungsquelle in Kontakt ist.

Ausgehend von diesem Stand der Technik liegt daher der Erfindung die Aufgabe zugrunde, unter Beibehalten der Vorteile der bekannten Lösungen, nämlich elektrische und/oder elektronische Geräte in funktionssicherer und platzsparender Weise in einem Schaltschrank zu integrieren, dahingehend weiter zu verbessern, dass eine Klimatisierungsanordnung, insbesondere Kühlanordnung geschaffen ist, die nicht nur sehr effizient arbeitet, sondern auch einen kompakten Aufbau ermöglicht und wartungsfreundlich ist. Eine dahingehende Aufgabe löst eine Klimatisierungsanordnung mit den Merkmalen des Patentanspruchs 1 in seiner Gesamtheit. Dadurch dass gemäß dem kennzeichnenden Teil des Patentanspruches 1 durch die abzuführende Wärme der Geräte auf der Vorderseite eine konvektive Strömung entsteht, die von unten nach oben führt und dass oberhalb der Geräte die vorderseitige Gesamtluftströmung von der Luftfördereinrichtung wiederum eingesaugt und über ihre Auslassöffnung eine auf der Rückseite des Rahmens von oben nach unten gerichtete Luftströmung erzeugt, von der einzelne Teilluftströme abgezweigt über die jeweilige Durchtrittsöffnung von der Rückseite des Rahmens auf die Vorderseite hindurchtreten und sich zu der vorderseitigen Gesamtluftströmung vereinigen , lässt sich innerhalb des Schaltschrankes ein im Wesentlichen homogenes Temperaturfeld trotz unterschiedlicher thermischer Belastung ausgehend von den elektrischen und/oder elektronischen Geräten erzielen, so dass eine gleichmäßige und dennoch wirkungsvolle Klimatisierung für die Geräte erreicht ist. Die als eigenständiges Bauteil konzipierte Wärmesenke lässt sich in kostengünstiger Weise in der einfachsten Ausführungsform als sogenannte "cold-plate" realisieren, die je nach ihrem thermischen Zustand eine Homogenisierung des Temperaturfeldes innerhalb des Schaltschrankes, insbesondere in kühlender Weise ermöglicht. Sofern die angesprochene "cold-plate" aus einer Metallplatte gebildet ist, ist diese in effizienter Weise thermisch leitend und kann insbesondere aus einer kühlen Ausgangssituation heraus, indem sie beispielsweise eine niedrige Umgebungstemperatur außerhalb des Schaltschrankes speichert, die dahingehende Niedrigtemperatur in das Innere des Schaltschrankes zur Gerätekühlung abgeben. Insbesondere erlaubt eine derart gekühlte Platte ("cold-plate"), dass insoweit die auf der Rückseite der Trageinrichtung befindliche Schaltschrankluft sturzartig bei aufgestelltem Schaltschrank von oben nach unten entlang der Rückseite der Trageinrichtung geführt wird, um dann auf deren Vorderseite unter dem Einfluss einer konvektiven Wärmeströmung, bedingt durch die Wärmeabfuhr der Geräte, an der Trageinrichtung wiederum nach oben aufzusteigen, wobei dann die Geräte entsprechend gekühlt werden.

Die angesprochene Wärmesenke ist also bevorzugt ein räumlich begrenzter eigenständiger Körper, der die in ihm gespeicherte oder zugeführte thermische Energie an ein angrenzendes Medium hier in Form von Luft abgibt und dass bevorzugt die Wärmesenkung eine Kühleinrichtung ist, die Abwärme abführt, um eine Überhitzung der Geräte im Schaltschrank zu vermeiden.

Es versteht sich jedoch, dass eine dahingehende Wärmesenke im Bedarfsfall im Sinne einer Klimatisierung auch zur Anwärmung der elektrischen und/oder elektronischen Geräte eingesetzt werden kann, insbesondere wenn die dahingehenden Geräte in ausgesprochen kalter Umgebung angeschaltet und insoweit dann erst noch in Betrieb genommen werden.

Die Wärmesenke, die eine plattenförmige Erstreckung unter Bildung der sogenannten "cold-plate" aufweist, kann einen Wandteil des Schaltschrankes ausbilden, vorzugsweise seine Rückwand; es besteht aber auch die Möglichkeit, eine dahingehende plattenförmige Wärmesenke innerhalb des Schaltschrankes zu integrieren, wobei jedoch darauf geachtet werden sollte, dass bei geöffneten Schaltschranktüren des Schaltschrankes die plattenförmige Wärmesenke nicht die Zugangsmöglichkeit zu den Geräten beeinträchtigt, was man dadurch verhindern kann, dass man beispielsweise die plattenförmige Wärmesenke als Bestandteil der jeweiligen Schaltschranktür ausgestaltet.

Eine andere Möglichkeit ist die Wärmesenke an einem Gebäude, insbesondere an Wandteilen einer Halle oder dergleichen, in der der jeweilige Schaltschrank aufgestellt wird, anzuordnen und dann vor der dahingehend gebäudetechnisch installierten Wärmesenke den Schaltschrank aufzustellen, um dergestalt die Klimatisierung des Schaltschrankinneren zu erreichen.

Bei einer weiteren besonders bevorzugten Ausführungsform der erfindungsgemäßen Anordnung ist vorgesehen, dass ein vorgebbarer Abstand zwischen der Trageinrichtung mit den Geräten und zuordenbarer Wärmesenke mittels einer Einstelleinrichtung einstellbar ist. Je nachdem, wie viele und welche Art von Geräten dann an der Trageinrichtung festgelegt sind, kann die thermische Eintragsbelastung innerhalb des Schaltschrankes unterschiedlich sein, und durch Einstellen des Abstandes zwischen Wärmesenke und Trageinrichtung kann dann der Grad der vorzusehenden Kühlleistung innerhalb des Schaltschrankes mit eingestellt werden.

Für eine optimierte Luftströmung innerhalb des Schaltschrankes mit Kühlluft ist vorgesehen, dass das Volumen des hinteren Strömungsraumes um ein Vielfaches kleiner bemessen ist als das Volumen des vorderen Strömungsraumes, wozu - auch um eine verbesserte Umwälzung innerhalb des Schaltschrankes zu erreichen - vorgesehen sein kann, dass die Zirkulation der strömenden Kühl- oder Warmluft durch eine Luftfördereinrichtung, vorzugsweise in Form mindestens eines Walzenlüfters, bewerkstelligt ist.

Energetisch aufwendiger, jedoch von der aufzubringenden Kühlleistung besser, ist es vorzusehen, dass ein gasförmiges Kältemittel durch Kühlrohre innerhalb der plattenförmigen Wärmesenke im Umlauf geführt ist, um dergestalt Wärme aus dem Inneren des Schaltschrankes in die Umgebung abführen zu können. Etwaig an der Wärmesenke entstehendes Kondensat kann innerhalb des Schaltschrankes mittels einer Sammeleinrichtung gesammelt und mittels einer Auslass- oder Austrageinrichtung aus dem Schaltschrank in die Umgebung abgeführt werden.

Weitere Vorteile, Merkmale und Einzelheiten der Erfindung ergeben sich aus den Unteransprüchen und der nachfolgenden Beschreibung, in der unter Bezugnahme auf die Zeichnungen verschiedene Ausführungsbeispiele im Einzelnen beschrieben sind. Dabei zeigen in prinzipieller und nicht maßstäblicher Darstellung:
- Fig. 1: eine perspektivische Ansicht auf einen erfindungsgemäßen Schaltschrank, und die
- Fig. 2 bis 4: in der Art einer Seitenansicht drei verschiedene Ausführungsbeispiele des erfindungsgemäßen Schaltschrankes nach der Fig. 1.

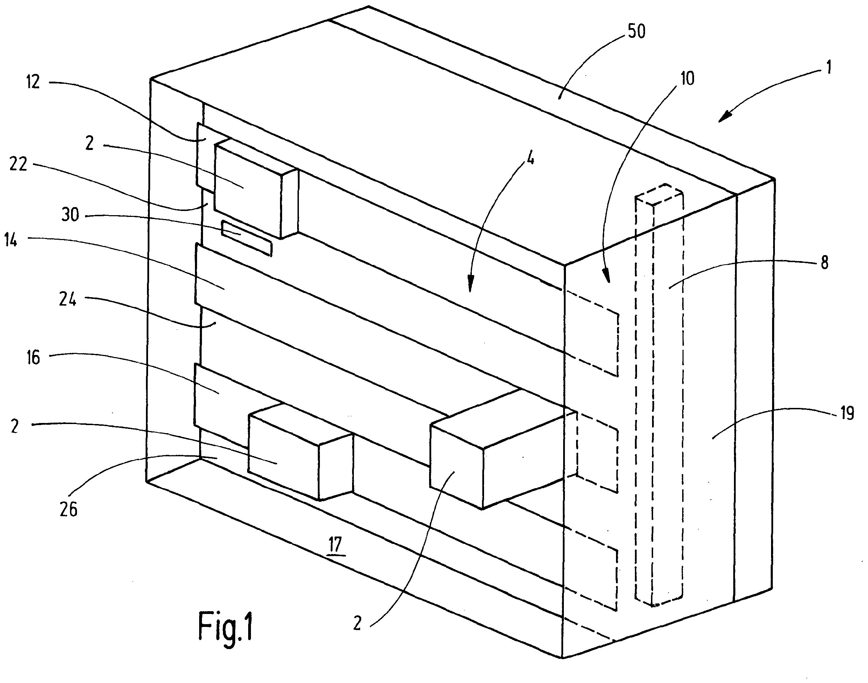

Die Fig. 1 zeigt eine perspektivische Ansicht auf einen erfindungsgemäßen Schaltschrank 1, wie er für die Montage elektrischer und/oder elektronischer Geräte 2, wie beispielsweise Steuereinrichtungen, Netzteile, Schalteinrichtungen, Sicherungen, Sensoren usw., bevorzugt in der industriellen Fertigungstechnik verwendet wird. Es sei an dieser Stelle betont, dass die technische Angabe Schaltschrank auch Einrichtungen umfassen soll wie Schaltkästen sowie sonstige Aufnahmebehältnisse für die angesprochene übliche Art an Geräten 2.

In dem Schaltschrank 1 ist eine nur schematisch dargestellte Trageinrichtung 4 angeordnet, die im Ausführungsbeispiel aus zwei oder mehreren vertikal verlaufenden Tragschienen 8 und im vorliegenden Fall insgesamt aus drei im Wesentlichen horizontal verlaufenden Montagestegen 12, 14, 16 zusammengesetzt ist. Die Verbindung zwischen den Montagestegen 12, 14, 16 und den Tragschienen 8 kann über in der Fig. 1 nicht dargestellte Verbindungselemente, beispielsweise in Form von Verbindungsbügeln oder dergleichen erfolgen, wobei die Montagestege 12, 14, 16 in Richtung der in der Fig. 1 ansichtigen Vorderseite 17 vor den Tragschienen 8 angeordnet sind. Die Tragschienen 8 und die Montagestege 12, 14, 16 bilden einen Rahmen 10 aus, der auch entsprechend vormontiert und anschließend in den Schaltschrank 1 als Trageinrichtung 4 für die Geräte 2 eingesetzt werden kann.

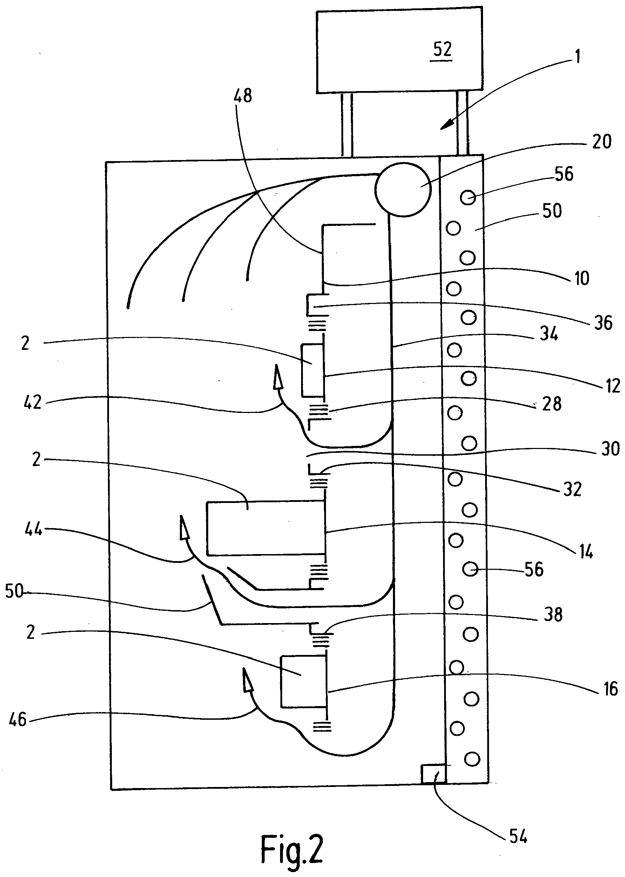

Auf der Vorderseite 17 der Montagestege 12, 14, 16 und mithin der Vorderseite 17 der rahmenförmigen Trageinrichtung 4 sind die Geräte 2 in Etagen übereinander angeordnet, insbesondere an jeweils zugehörige Montagestege 12, 14, 16, vorzugsweise lösbar befestigt. Die dahingehende Vorderseite 17 des Schaltschranks 1 kann mit einer in der Fig. 1 aus Gründen der einfacheren Darstellung wegen nicht näher dargestellten Schaltschranktür verschließbar sein, wobei die dahingehende Öffnung des Schaltschrankes 1 auch durch eine Doppel- oder sonstige Mehrfachtür verschließbar ist. Auf der Rückseite 19 der Trageinrichtung 4, insbesondere im Bereich der Tragschienen 8 ist mittels einer Luftfördereinrichtung 20 (Fig. 2) eine Luftströmung 34 erzwingbar, die im Wesentlichen von oben nach unten in Richtung der Pfeillinien erfolgt.

Die Stegzwischenräume zwischen den Montagestegen 12, 14, 16 sind mittels Verschlusselementen 22, 24, 26 mindestens teilweise verschließbar, wobei im Bereich dieser Stegzwischenräume auch elektrische Anschlussleitungen der Geräte 2 von der Vorderseite 17 des Rahmens 10 auf die Rückseite 19 geführt werden, und insoweit die Verdrahtung und Kabelführung dementsprechend auf der Rückseite 19 der rahmenförmigen Trageinrichtung 4 verlaufen kann. Zu diesem Zweck können die Verschlusselemente 22, 24, 26 jeweils mehrteilig ausgebildet sein, insbesondere beispielsweise einen Verdrahtungskamm 28 (Fig. 2) und ein Deckelelement 32 aufweisen. Die dahingehenden Verschlusselemente sowie der Verdrahtungskamm nebst Deckelelement sind nur exemplarisch und nur in prinzipieller Art und Weise der einfacheren Darstellung wegen wiedergegeben.

In dem Deckelelement 32 ist eine Durchtrittsöffnung 30 angeordnet, über welche kühlende Luft von der Rückseite 19 auf die Vorderseite 17 der Trageinrichtung 4 hindurchtreten kann und dadurch gezielt dem wärmeerzeugenden jeweiligen Gerät 2 zuführbar ist. In der Ansicht nach der Fig. 1 ist lediglich die Durchtrittsöffnung 30 für das zuoberst dargestellte linke Gerät sichtbar; dessen ungeachtet ist auch in dem zweiten Verschlusselement 24 und in dem dritten Verschlusselement 26 jeweils eine Durchtrittsöffnung für das zweite bzw. dritte Gerät 2 angeordnet. Anstelle der hier aufgezeigten Lösung kann die Luft aber auch durch jede sonstige Öffnung von der Rückseite 19 auf die Vorderseite 17 des Schaltschrankes 1 geführt werden; insbesondere wäre es denkbar die Kühlluft einfach zwischen den horizontal verlaufenden Montagestegen 12, 14, 16 hindurchströmen zu lassen.

Die Figuren 2 bis 4 zeigen jeweils in stark vereinfachter Weise eine Seitenansicht auf Ausführungsbeispiele des erfindungsgemäßen Schaltschrankes 1. Die Luftfördereinrichtung 20 ist im jeweils vorliegenden Ausführungsbeispiel als Querstromlüfter oder Walzenlüfter ausgebildet und saugt die Luft im oberen Bereich des Inneren des Schaltschranks 1 an und fördert sie auf die Rückseite 19 des Rahmens 10, respektive der Trageinrichtung 4. Die Luftfördereinrichtung 20 erzwingt insoweit während ihres Betriebes eine auf der Rückseite 19 des Rahmens 10 von oben nach unten gerichtete Luftströmung 34 von der einzelne Teilluftströme 42, 44, 46 abgezweigt werden, die über beispielsweise die Durchtrittsöffnung 30 von der Rückseite 19 des Rahmens 10 auf die Vorderseite 17 hindurchtreten, auf der die elektrischen Geräte 2 angeordnet sind. Auf der Vorderseite 17 können sich dann die Teilluftströme zu einer vorderseitigen Gesamtluftströmung vereinigen. Die dahingehende Luftführung ist wiederum in Pfeildarstellung wiedergegeben. Der beispielsweise durch die Durchtrittsöffnung 30 hindurchtretende Teilluftstrom 42 überstreicht dabei das in Fig. 1 oben links dargestellte Gerät 2, dem eben die Durchtrittsöffnung 30 entsprechend zugeordnet ist, noch bevor sich der Teilluftstrom 42 auf der Vorderseite 17 des Rahmens 10 mit den weiteren Teilluftströmen 44, 46 vereinigen kann. Insgesamt entsteht aber bereits durch die abzuführende Wärme der Geräte 2 auf der Vorderseite 17 im Schaltschrank 1 eine konvektive Strömung, die von unten nach oben führt. Mithin wird oberhalb der Geräte 2 die vorderseitige Gesamtluftströmung von der Luftfördereinrichtung 20 wiederum eingesaugt und über ihre Auslassöffnung nach unten hin entlang der Rückseite 19 der Trageinrichtung 4 transportiert, so dass eine permanente Umwälzung der Luft im geschlossenen Schaltschrank 1 stattfindet.

Oberhalb des ersten Montagesteges 12 ist in prinzipieller Art und Weise ein Befestigungselement 48 angeordnet, an dem die Luftfördereinrichtung 20 angeschlossen, insbesondere montiert ist. Ein erster Stegzwischenraum zwischen dem Befestigungselement 48 und dem ersten Montagesteg 12 ist mittels eines den Rahmen 10 an dieser Stelle im Wesentlichen luftdicht abschließenden Deckelelementes 36 verschlossen. Dagegen ist in den Stegzwischenraum zwischen dem ersten Montagesteg 12 und dem zweiten Montagesteg 14 ein erstes Deckelelement 32 angeordnet, das die Durchtrittsöffnung 30 aufweist. Das erste Deckelelement 32 kann dabei in die von den Verdrahtungskämmen 28 begrenzenden Seitenränder des Stegzwischenraums einsteckbar sein. Die Durchtrittsöffnung 30 kann dabei in dem ersten Deckelelement 32 vorgegeben sein oder das erste Deckelelement 32 kann durch lokale Materialausdünnung, Perforation oder dergleichen Sollbruchstellen aufweisen, mittels denen die Durchtrittsöffnung 30 einfach und vorzugsweise werkzeuglos im Bedarfsfall herstellbar ist. Auch können bei einer vereinfachten Bauform die Durchtrittsräume zwischen den einzelnen Montagestegen 12, 14, 16 genutzt werden, um die Luft von der Rückseite 19 in Richtung der Vorderseite 17 zwecks Klimatisieren der Geräte 2 zu transportieren.

Da das in Fig. 1 exemplarisch dargestellte mittlere Gerät 2 eine verhältnismäßig große Bauhöhe aufweist, ist in den Stegzwischenraum zwischen dem zweiten Montagesteg 14 und dem dritten Montagesteg 16 ein zweites Deckelelement 30 eingesetzt, in dessen Durchtrittsöffnung ein Luftleitelement 50 eingesetzt ist, vorzugsweise lösbar eingesteckt ist, mittels dem die insoweit hindurchtretende kühlende Luft gezielt an das vordere Ende des zweiten Gerätes 2 zuführbar ist. In entsprechender Weise kann das Luftleitelement 50 gekühlte Luft alternativ oder ergänzend auch in horizontaler Richtung verteilen.

Unterhalb des dritten Montagesteges 16 ist eine sich über die gesamte Breite des dritten Montagesteges 16 erstreckende Durchtrittsöffnung angeordnet, über welche der verbleibende Luftstrom 34 von der Rückseite 19 auf die Vorderseite 17 des Rahmens 10 hindurchtreten kann und zunächst über das dritte Gerät 2 (ganz unten auf der linken Seite in Fig. 1 dargestellt) kühlend streifen kann und anschließend nach oben in Richtung auf die Luftfördereinrichtung 20 abgesaugt wird. Der Aufbau der Trageinrichtung 4, respektive des Rahmens 10 ist nur beispielhaft, und in der Praxis sind die dahingehenden Komponenten mit wesentlich mehr Montagestegen in horizontaler und vertikaler Anordnung ausgestattet als hier exemplarisch zur Erläuterung der Erfindung aufgezeigt.

Ausgehend von den vorstehend beschriebenen grundsätzlichen Aufbauten eines Schaltschrankes wird nunmehr die erfindungsgemäße Klimatisierungsanordnung näher beschrieben. Wie die Fig. 1 zeigt, ist auf der Rückseite des Schaltschrankes 1 als eigenständiges Bauteil 50 eine Wärmesenke angeordnet, die die innerhalb des Schaltschrankes 1 befindlichen Geräte 2 klimatisiert, vorzugsweise entsprechend kühlt. Die in Fig. 1 gezeigte Wärmesenke 50 ist ein räumlich begrenzter, eigenständiger Körper, der die in ihm gespeicherte oder zugeführte thermische Energie an ein angrenzendes Medium, wie vorzugsweise Luft, abgibt, wobei bevorzugt die Wärmesenke 50 eine Kühleinrichtung ist, die Abwärme abführt, um eine Überhitzung der Geräte 2 im Schaltschrank 1 zu vermeiden.

Im Ausführungsbeispiel nach der Fig. 1 weist die Wärmesenke 50 eine plattenförmige Erstreckung auf und bildet bevorzugt ein rückseitiges Wandteil des Schaltschrankes 1 aus. Insoweit ist also der Schaltschrank 1 auf seiner Rückseite durch die Wärmesenke 50 derart abgedeckt, dass die Seitenwände der Wärmesenke 50 bündig in die Seitenwände des Schaltschrankes 1 übergehen. In der einfachsten Ausführungsform ist die Wärmesenke 50 als sogenannte "cold-plate" ausgebildet, die eine niedrige Umgebungstemperatur außerhalb des Schaltschrankes 1 entsprechend speichern und dann an das Innere des Schaltschrankes 1 weiter abgeben kann. Durch die dahingehende Kühlung der als "cold-plate" ausgebildeten Wärmesenke 50 verstärkt sich das bereits beschriebene Wärmesturzgefälle auf der Rückseite 19 des Schaltschrankes 1.

Wie das Ausführungsbeispiel nach der Fig. 2 zeigt, kann die Wärme- oder Temperatursenke 50 als Kühlplatte einer Kühleinrichtung ausgebildet sein, die insbesondere mit einem Verdampfer oder einer Kompressionskältemaschine 52 zusammenwirkt, die gemäß der Darstellung nach der Fig. 2 zusammen mit ihrem Kompressor und Kondensator über dem Schaltschrank 1 außerhalb desselben angeordnet ist. Die Regelung der Temperatur der Kühlluft erfolgt dabei vorzugsweise derart, dass nach Möglichkeit auch bei ungünstigen klimatischen Bedingungen an dem Verdampfer keine Kondensation erfolgt. Etwaig in dem Schaltschrank 1 auftretendes Kondensat wird mittels einer hohlschienenartigen Sammeleinrichtung 54 gesammelt und über eine nicht näher dargestellte Auslasseinrichtung aus dem Schaltschrank 1 abgeführt.

Vorzugsweise ist für die dahingehende Auslegung die als Kühlplatte ausgebildete Wärmesenke 50 in der Art einer Sandwich-Konstruktion konzipiert, bestehend aus einem plattenförmigen Trägermedium, in dem bevorzugt mäanderförmig verlegte Kühlschlangen oder Kühlleitungen 56 eingebettet sind. Die Kühlleitungen oder Kühlrohre 56 sind mit ihrem Vor- und Rücklauf jeweils an dem Kältekompressor 52 angeschlossen, der zusammen mit dem zugehörigen Kondensator außerhalb des Schaltschranks 1 an dessen Oberseite ortsfest angeordnet ist, um so innerhalb des Schaltschranks keinen Bauraum zu belegen. Die Anschlüsse der Kühlrohre 56 an dem auf der Oberseite des Schaltschranks 1 ausgelagerten Kältekompressor 12 erfolgt durch nicht näher dargestellte trennbare Kupplungen, wodurch eine einfache Wartung des Kältekompressors 12 möglich ist oder der einfache Austausch einzelner Komponenten der Gesamtkühlanordnung vorgenommen werden kann, sobald man den Kompressor 52 über die trennbare Kupplungen von der sonstigen Wärmesenke 50 separiert.

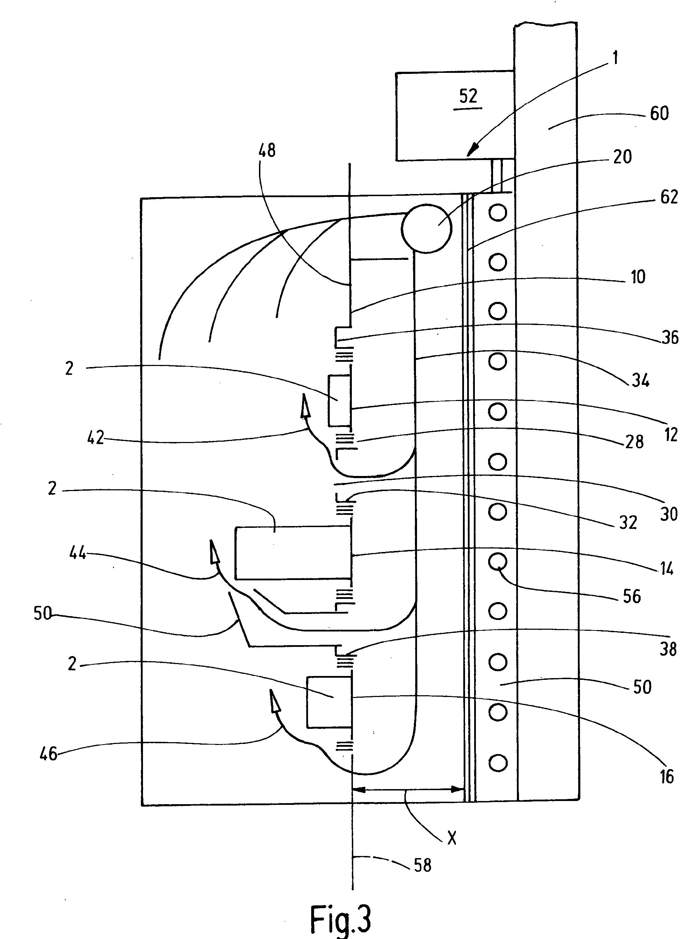

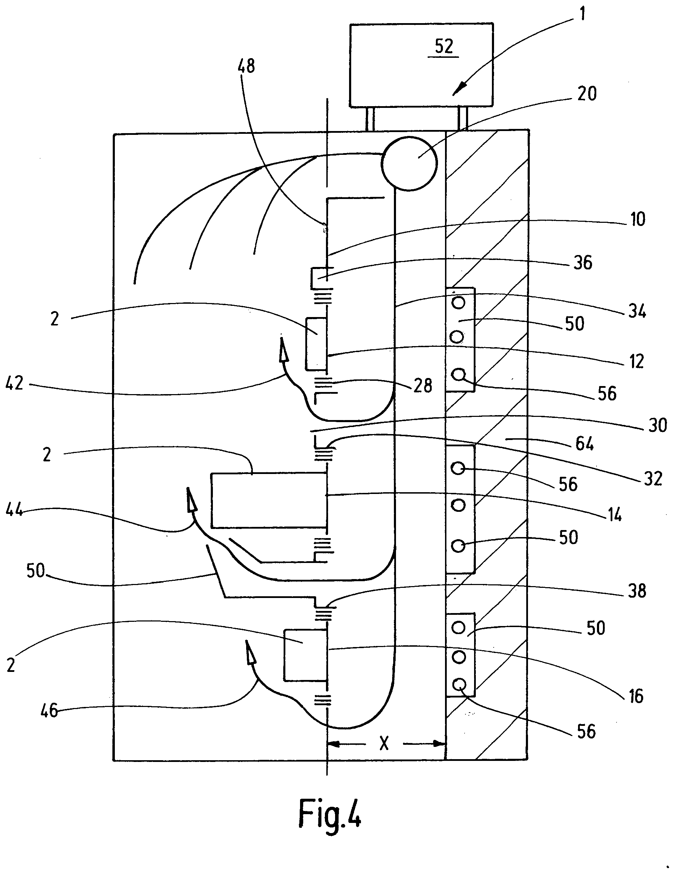

Die nachfolgenden Ausführungsbeispiele werden nur noch insofern erläutert, als sie sich wesentlich von den vorangehenden Ausführungsbeispielen unterscheiden. Die insoweit hierzu getroffenen Ausführungen gelten dann entsprechend auch für die nachfolgend vorgestellten Ausführungsbeispiele nach den Figuren 3 und 4.

Bei der Ausführungsform nach der Fig. 3 erfolgt die Befestigung des Rahmens 10, also der Trageinrichtung 4 in dem Schaltschrank 1 mittels einer fest eingebauten sogenannten Servoachse 58, an der der eigentliche Rahmen 10 in der Höhe; jedoch besonders bevorzugt in verstellbarem Abstand X zu der gekühlten, rückseitig angeordneten Wärmesenke 50 gehalten ist. Ferner ist im vorliegenden Ausführungsbeispiel die Wärmesenke 50 mit bodenseitigem Anschluss vor eine Gebäudewand 60 gestellt, die Teil einer Aufstellungshalle für den Schaltkasten 1 sein kann, wobei dann insoweit auch der Kompressor 52 an der Gebäudewand 60 festgelegt ist. Die dahingehende wandseitige Anordnung kann sich auch entlang einer größeren Hallenwand erstrecken, so dass mehrere Schaltschränke 1 mit ihrer rückseitig dann offen gebliebenen Hohlkastenkonstruktion vor die jeweilige Wärmesenkeanordnung 50 gestellt werden können. In Blickrichtung auf die Fig. 3 gesehen auf der Vorderseite der Wärmesenke 50 ist eine Nanolackbeschichtung 62 aufgetragen, die selbständig die Abreinigung der Wärmesenke 50 von Verschmutzungen in diesem Bereich ermöglicht bzw. die Abreinigung entsprechend erleichtert. Insoweit könnte die Wärmesenke 50 wiederum bündig die Rückseite des Schaltschrankes 1 abschließen oder entsprechend randseitig in Verlängerung übergreifen, um dergestalt die Aufstellmöglichkeiten mehrerer Schaltschränke 1 (nicht dargestellt) für nur eine Wärmesenkeplatte zu ermöglichen.

Bei der Ausführungsform nach der Fig. 4 sind mehrere plattenförmige Wärmesenken 50 jeweils einem Gerätebereich 2 der Trageinrichtung 4 zugeordnet und ansonsten rückwärtig über eine Dämmung 64 vor Kälteverlusten in die Umgebung geschützt. Sofern die vorstehenden Ausführungsbeispiele im Wesentlichen den Kühlaspekt in den Vordergrund stellen, kann die jeweilige Wärmesenke 50 auch für eine Wärmetemperierung für die Geräte 2 des Schaltschrankes 1 vorgesehen sein, um beispielsweise bei Aufstellorten des Schaltschrankes 1 bei sehr tiefen Temperaturen die Geräte 2 im Sinne einer Erwärmung zu klimatisieren, um dergestalt deren Funktionsfähigkeit rasch sicherstellen zu können. Je nach Ausgestaltung treten dann neben den Kühlrohren 56 zusätzlich oder alternativ entsprechend ausgestaltete Wärmemedium führende Wärmeleitungen auf, wobei auch eine elektrische Beheizung der Wärmesenke 50 angedacht sein kann.

Aufgrund des modularen Aufbaus der jeweiligen Wärmesenke 50 lassen sich eine Vielzahl von Anwendungsmöglichkeiten für Schaltschränke 1 realisieren. So wäre auch denkbar, die jeweilige Wärmesenke 50 frontseitig in die nicht näher dargestellten Türsysteme für den Schaltschrank 1 zu integrieren oder dessen sonstige Wandteile miteinzubeziehen, wie beispielsweise Ständerfußteile, Seitenwände und Oberseitenwand.

## Patentansprüche

1. Klimatisierungsanordnung, insbesondere Kühlanordnung, zumindest aufweisend einen Schaltschrank (1) mit einer Trageinrichtung (4), an deren den Schaltschranktüren zugewandten Vorderseite (17) zu klimatisierende elektrische und/oder elektronische Geräte (2) in Etagen über- und nebeneinander angeordnet sind, wobei mittels mindestens einer Wärmesenke (50) als einem jeweils eigenständigen Bauteil die innerhalb des Schaltschrankes (1) befindlichen Geräte (2) zumindest teilweise klimatisierbar sind, wobei zwischen der jeweiligen Wärmesenke (50) und der Rückseite (19) der jeweils zuordenbaren Trageinrichtung (4) ein hinterer Strömungsraum vorhanden ist, mittels dessen eine absinkende Luftströmung bei aufgestelltem Schaltschrank (1) von oben nach unten erzwingbar ist, wobei ein vorderer Strömungsraum zwischen der Trageinrichtung (4) und der jeweiligen Schaltschranktür eine aufsteigende Luftströmung erlaubt, die zumindest teilweise an den wärmeerzeugenden Geräten (2) vorbeigeführt ist, wobei die Trageinrichtung (4) mit Durchlässen (30) versehen ist, die jeweils eine direkte Querverbindung von hinterem zu vorderem Strömungsraum derart ermöglichen, dass die zuordenbaren Geräte (2) im Schaltschrank (1) sowohl stirnseitig als auch seitlich angeströmt sind, und wobei die Zirkulation der strömenden Kühl- oder Warmluft durch eine Luftfördereinrichtung (20) bewerkstelligt ist, **dadurch gekennzeichnet, dass** durch die abzuführende Wärme der Geräte (2) auf der Vorderseite (17) eine konvektive Strömung entsteht, die von unten nach oben führt und dass oberhalb der Geräte (2) die vorderseitige Gesamtluftströmung von der Luftfördereinrichtung (20) wiederum eingesaugt und über ihre Auslassöffnung eine auf der Rückseite (19) des Rahmens (10) von oben nach unten gerichtete Luftströmung (34) erzeugt, von der einzelne Teilluftströme (42, 44, 46) abgezweigt über die jeweilige Durchtrittsöffnung (30) von der Rückseite (19) des Rahmens (10) auf die Vorderseite (17) hindurchtreten und sich zu der vorderseitigen Gesamtluftströmung vereinigen.

2. Anordnung nach Anspruch 1, **dadurch gekennzeichnet, dass** die Wärmesenke (50) ein räumlich begrenzter, eigenständiger Körper ist, der in ihm gespeicherte oder zugeführte thermische Energie an ein angrenzendes Medium, wie vorzugsweise Luft, abgibt und dass bevorzugt die Wärmesenke (50) eine Kühleinrichtung ist, die Abwärme abführt, um eine Überhitzung der Geräte (2) im Schaltschrank (1) zu vermeiden.

3. Anordnung nach Anspruch 1 oder 2, **dadurch gekennzeichnet, dass** die Wärmesenke (50) eine plattenförmige Erstreckung aufweist und mindestens ein Wandteil des Schaltschrankes (1) ausbildet und/oder im Schaltschrank (1) integrierbar ist oder außerhalb des Schaltschrankes (1) in dessen unmittelbarer Nachbarschaft den Schaltschrank oder Wandteile desselben überdeckt bzw. abdeckt.

4. Anordnung nach einem der vorstehenden Ansprüche, **dadurch gekennzeichnet, dass** ein vorgebbarer Abstand (X) zwischen Trageinrichtung (4) und zuordenbarer Wärmesenke (50) mittels einer Einstelleinrichtung (58) einstellbar ist.

5. Anordnung nach einem der vorstehenden Ansprüche, **dadurch gekennzeichnet, dass** das Volumen des hinteren Strömungsraumes um ein Vielfaches kleiner bemessen ist als das Volumen des vorderen Strömungsraumes

6. Anordnung nach einem der vorstehenden Ansprüche, **dadurch gekennzeichnet, dass** die Luftfördereinrichtung (20) ein Walzenlüfter ist.

7. Anordnung nach einem der vorstehenden Ansprüche, **dadurch gekennzeichnet, dass** ein gasförmiges Kältemittel durch Kühlrohre (56) innerhalb der plattenförmigen Wärmesenke (50) im Umlauf geführt ist, das durch eine Kompressoreinrichtung (52), vorzugweise adiabatisch, verdichtet ist, wodurch das Kältemittel sich erwärmt, das über die Kühlrohre (56) der Wärmesenke (50) aufgenommene Wärme an die Umgebung abgibt.

8. Anordnung nach einem der vorstehenden Ansprüche, **dadurch gekennzeichnet, dass** die Wärmesenke (50) auf ihrer der Trageinrichtung (4) zugewandten Vorderseite mit einer Nano-Struktur, vorzugsweise in Form eines Nano-Lackes (62), versehen ist.

9. Anordnung nach einem der vorstehenden Ansprüche, **dadurch gekennzeichnet, dass** etwaig bei Betrieb der Wärmesenke (50) entstehendes Kondensat mittels einer Sammeleinrichtung (54) gesammelt und mittels einer Auslasseinrichtung aus dem Schaltschrank (1) abgeführt ist.

## Claims

1. Air conditioning assembly, in particular cooling assembly, comprising at least one control cabinet (1) with a support device (4), on the front side (17) of which, directed towards the control cabinet doors, electrical and/or electronic devices (2) that are to be air-conditioned are arranged in tiers one above the other and side by side, wherein by means of at least one heat sink (50), as an independent component in each case, the devices (2) located inside the control cabinet (1) can be at least partially air-conditioned, there being, between the respective heat sink (50) and the rear side (19) of the respectively assignable support device (4), a rear flow chamber by means of which a descending airflow can be forced from top to bottom when the control cabinet (1) is in position, wherein a front flow chamber between the support structure (4) and the respective control cabinet door permits an ascending airflow which is guided at least partially past the heat-generating devices (2), wherein the support device (4) is provided with apertures (30) which each permit a direct transverse connection from the rear flow chamber to the front flow chamber in such a way that the assignable devices (2) in the control cabinet (1) are exposed to the flow from both the front and from the side, and wherein the circulation of the flowing cool or warm air is effected by an air conveying device (20), **characterised in that** the heat to be dissipated from the devices (2) produces a convective flow on the front side (17) which leads from bottom to top, and **in that** above the devices (2) the total airflow on the front side is in turn sucked in by the air conveying device (20) and via its outlet aperture produces an airflow (34) which is directed from top to bottom on the rear side (19) of the frame (10), from which individual partial airflows (42, 44, 46), branched off via the respective openings (30), pass from the rear side (19) of the frame (10) to the front side (17) and combine to form the total airflow on the front side.

2. Assembly according to claim 1, **characterised in that** the heat sink (50) is a spatially limited, independent body which releases thermal energy, stored therein or supplied to it, to an adjacent medium, such as preferably air, and **in that** the heat sink (50) is preferably a cooling device which dissipates waste heat to prevent the devices (2) in the control cabinet (1) from overheating.

3. Assembly according to claim 1 or 2, **characterised in that** the heat sink (50) comprises a plate-shaped extension and forms at least one wall part of the control cabinet (1) and/or can be integrated into the control cabinet (1) or overlaps or covers the control cabinet or wall parts thereof outside the control cabinet (1) in the immediate vicinity thereof.

4. Assembly according to one of the preceding claims, **characterised in that** a specifiable distance (X) can be adjusted between support device (4) and assignable heat sink (50) by means of an adjusting device (58).

5. Assembly according to one of the preceding claims, **characterised in that** the volume of the rear flow chamber is designed to be many times smaller than the volume of the front flow chamber.

6. Assembly according to one of the preceding claims, **characterised in that** the air conveying device (20) is a roller-type fan.

7. Assembly according to one of the preceding claims, **characterised in that** a gaseous refrigerant is circulated through cooling tubes (56) inside the plate-shaped heat sink (50), said refrigerant being compressed, preferably adiabatically, by a compressor device (52), as a result of which the refrigerant heats up, releasing the heat absorbed via the cooling tubes (56) of the heat sink (50) into the environment.

8. Assembly according to one of the preceding claims, **characterised in that** the heat sink (50) is provided on its front side, directed towards the support device (4), with a nanostructure, preferably in the form of a nanopaint (62).

9. Assembly according to one of the preceding claims, **characterised in that** any condensate arising during operation of the heat sink (50) is collected by means of a collecting device (54) and discharged from the control cabinet (1) by means of an outlet device.

## Revendications

1. Installation de conditionnement d'air, notamment installation de refroidissement, ayant au moins une armoire (1) de commande ayant un dispositif (4) porteur sur la face (17) avant, tournée vers les portes de l'armoire de commande, duquel sont superposés et juxtaposés en étage des appareils (2) électriques et/ou électroniques à climatiser, dans laquelle, au moyen d'au moins un puits (50) de chaleur, comme composant autonome respectif, les appareils (2) se trouvant à l'intérieur de l'armoire (1) de commande peuvent être climatisés au moins en partie, dans laquelle, entre le puits (50) de chaleur respectif et la face (19) arrière du dispositif (4) porteur, pouvant être associé respectivement, est présent un espace d'écoulement arrière, au moyen duquel un écoulement d'air descendant peut être forcé de haut en bas lorsque l'armoire (1) de commande est installée, dans laquelle un espace d'écoulement avant, entre le dispositif (4) porteur et la porte respective de l'armoire de commande, autorise un écoulement d'air ascendant, qui passe, au moins en partie, devant les appareils (2) produisant de la chaleur, dans laquelle le dispositif (4) porteur est pourvu de traversées (30), qui permettent chacune une liaison transversale directe de l'espace d'écoulement arrière à l'espace d'écoulement avant, de manière à ce que les appareils (2) pouvant être associés dans l'armoire (1) de commande soient léchés à la fois du côté frontal et du côté latéral, et dans laquelle la circulation de l'air de refroidissement ou de l'air chaud en écoulement est provoquée par un dispositif (20) de refoulement de l'air, **caractérisée en ce que**, par la chaleur à évacuer des appareils (2), il se crée, sur la face (17) avant, un écoulement par convection, qui va du bas vers le haut, et **en ce qu'**au dessus des appareils (2), l'écoulement d'air total est aspiré à nouveau du côté avant par le dispositif (20) de refoulement de l'air et produit, par l'ouverture de sortie de celui-ci, un écoulement (34) d'air, qui est dirigé de haut en bas sur la face (19) arrière du cadre (10) et duquel sont dérivés divers courants (42, 44, 46) partiels , qui passent, par l'ouverture (30) de passage respective, de la face (19) arrière du cadre (10) à la face (17) avant et se réunissent en le courant d'air total du côté avant.

2. Installation suivant la revendication 1, **caractérisée en ce que** le puits (50) de chaleur est un corps autonome de limite dans l'espace, qui cède de l'énergie thermique, qui y est emmagasinée ou qui y est apportée, à un fluide voisin, comme par exemple de l'air, et **en ce que**, de préférence, le puits (50) de chaleur est un dispositif de refroidissement, qui évacue la chaleur dissipée pour empêcher une surchauffe des appareils dans l'armoire (1) de commande.

3. Installation suivant la revendication 1 ou 2, **caractérisée en ce que** le puits (50) de chaleur a une étendue en forme de plaque et constitue au moins une partie de paroi de l'armoire (1) de commande et/ou peut être intégré dans l'armoire (1) de commande ou surmonte ou recouvre l'armoire de commande ou les parties de paroi de celle-ci à l'extérieur de l'armoire (1) de commande dans sa proximité immédiate.

4. Installation suivant l'une des revendications précédentes, **caractérisée en ce qu'**une distance (X) pouvant être donnée à l'avance, entre le dispositif (4) porteur et un puits (50) de chaleur pouvant être associé, est réglable au moyen d'un dispositif (58) de réglage.

5. Installation suivant l'une des revendications précédentes, **caractérisée en ce que** le volume de l'espace d'écoulement arrière est plus petit d'un multiple que le volume de l'espace d'écoulement avant.

6. Installation suivant l'une des revendications précédentes, **caractérisée en ce que** le dispositif (20) de refoulement de l'air est un ventilateur à cylindre.

7. Installation suivant l'une des revendications précédentes, **caractérisée en ce qu'**un fluide réfrigérant gazeux passe en circulation fermée dans des tubes (56) de refroidissement à l'intérieur du puits (50) de chaleur en forme de plaque, en étant comprimé, de préférence adiabatiquement, par un dispositif (52) de compresseur, grâce à quoi le fluide réfrigérant s'échauffe, la chaleur absorbée par les tubes (56) de refroidissement du puits (50) de chaleur étant cédés à l'atmosphère ambiante.

8. Installation suivant l'une des revendications précédentes, **caractérisée en ce que** le puits (50) de chaleur est pourvu, sur son côté avant tourné vers le dispositif (4) porteur, d'une nanostructure, de préférence sous la forme d'un nano-vernis (62).

9. Installation suivant l'une des revendications précédentes, **caractérisée en ce que** du produit condensé, se produisant éventuellement lors du fonctionnement du puits (50) de chaleur, est accumulé au moyen d'un dispositif (54) d'accumulation et est évacué de l'armoire (1) de commande au moyen d'un dispositif d'évacuation.
